# EUROPEAN PATENT APPLICATION

(11) **EP 4 521 570 A1**
(43) Date of publication of application: **12.03.2025**
(21) Application number: 23202651.8
(22) Date of filing: 10.10.2023
(51) Int. Cl.: H02B 1/30, H02G 1/00

(54) **CHARGER**

(30) Priority: 06.09.2023 KR 20230118610
(71) Applicant: LG Electronics Inc., Yeongdeungpo-gu Seoul 07336 (KR); Mirae Korea Co., Ltd., Cheonan-si, Chungcheongnam-do 31040 (KR)
(72) Inventor: KIM, Cheolsoo, 06772 Seoul (KR); HAN, Dongkwon, 31040 Chungcheongnam-do (KR)
(74) Representative: Vossius & Partner Patentanwälte Rechtsanwälte mbB

(57) **Abstract**

An example of the charger of this embodiment comprises a cabinet body with a space formed inside of the cabinet body; and a door configured to open and close the space. The cabinet body may comprise a base; a corner pillar erected on the base; a gasket disposed on the corner pillar; and an outer cover fitted between the gasket and the corner pillar. A cover insertion hole into which the outer cover is inserted and a drain channel through which water is drained may be formed at the corner pillar. An end of the outer cover is slidably inserted into the cover insertion hole.

## Description

The present invention relates to a charger.

A charger is a device used to charge a storage battery.

An example of the charger may be an electric vehicle charger that charges a vehicle such as an electric vehicle, and electrical energy is supplied to a battery of the electric vehicle by connecting a charging connector provided at an end of a charging cable to a connection inlet installed in the electric vehicle.

It is desirable for the charger to minimize corrosion, and Korea Patent Publication No. 10-2394943 B1 (announced on May 9, 2022) discloses a charging station that can minimize corrosion, and the charging station comprises a main body with an internal space; a cabinet including first and second doors installed on both sides of the main body so that the user can open and close the internal space from different directions, and a ventilation unit installed in the main body to ventilate the air in the internal space class; and a canopy including a pair of supports installed to be spaced apart from each other, and a roof unit installed on top of the supports and covering the upper portion of the cabinet.

An object of the present embodiment is to provide a charger that has a simple appearance and minimizes water infiltration and rust generation.

An object of the present embodiment is to provide a charger that facilitates assembly of the cabinet body.

An example of the charger of this embodiment comprises a cabinet body with a space formed inside of the cabinet body; and a door configured to open and close the space.

The cabinet body may comprise a base; a corner pillar erected on the base; a gasket disposed on the corner pillar; and an outer cover fitted between the gasket and the corner pillar.

A cover insertion hole into which the outer cover is inserted and a drain channel through which water is drained may be formed at the corner pillar.

An end of the outer cover is slidably inserted into the cover insertion hole.

The cover insertion hole and the drain channel may be in communication.

The corner pillar may comprise a gasket coupling body surrounded by the gasket.

The corner pillar may comprise a sliding guide guiding an insertion of the outer cover.

The sliding guide may be parallel to the gasket coupling body.

The corner pillar may comprise a pillar body in which the cover insertion hole and the drain channel are formed, and the gasket coupling body and the sliding guide may protrude from an outer surface of the pillar body.

The gasket coupling body may be located inside the sliding guide.

A stopper may be formed in the corner pillar, and the end of the outer cover may be caught by contacting the stopper.

A base drain channel through which water is guided may be formed on an upper surface of the base.

A plurality of drain holes through which water falls may be formed on the base drain channel.

The plurality of drain holes may comprise a main drain hole, the main drain hole may be formed below the drain channel, and the main drain hole may face the drain channel in an upward and downward direction.

The plurality of drain holes may comprise a sub drain hole spaced apart from the main drain hole.

A pair of ribs may be formed on an upper surface of the base, the pair of ribs may be horizontally spaced apart from each other, and the charger may further comprise a base gasket mounted on the pair of ribs.

The corner pillar may be an aluminum extrusion pillar,

The outer cover may be a steel plate.

The door may comprise an outer door forming an exterior of the door; and an inner door disposed inside the outer door and bent at least once.

An accommodating space in which all or part of the inner door accommodated may be formed in the outer door.

The inner door may be inserted inside the outer door and fixed to the outer door.

The outer door may be a steel plate.

The inner door may be an aluminum extrusion door.

Another example of the charger of this embodiment comprises a plurality of the cabinet bodies and the plurality of the cabinet may be arranged in a row.

A pair of adjacent cabinet bodies comprises a common pillar and a first cover insertion hole and a second cover insertion hole are formed at the common pillar. An end of an outer cover of one of adjacent cabinet bodies may be slid into the first cover insertion hole, and an end of an outer cover of the other of the adjacent cabinet bodies may be slid into the second cover insertion hole. The first cover insertion hole and the second cover insertion hole may be open in opposite directions.

### BRIEF DESCRIPTION OF THE DRAWINGS

FIG. 1 is a perspective view of an example charger according to this embodiment;
FIG. 2 is a perspective view when the door shown in Figure 1 is opened;
FIG. 3 is an exploded perspective view of an example of a charger according to this embodiment;
FIG. 4 is a view when the outer cover and top cover according to this embodiment are separated;
FIG. 5 is an enlarged perspective view when the outer cover according to this embodiment is coupled to the corner pillar;
FIG. 6 is a perspective view showing a corner pillar and base according to this embodiment;
FIG. 7 is a perspective view when the corner pillar according to this embodiment is separated from the base;
FIG. 8 is a partially cut away perspective view showing a door according to this embodiment;
FIG. 9 is an exploded perspective view showing another example of the cabinet body according to this embodiment;
FIG. 10 is an enlarged view when the top cover shown in Figure 9 covers the top of the corner pillar;
FIG. 11 is a perspective view of another example of the charger according to this embodiment when the door is opened;
FIG. 12 is a plan view when the outer cover of each of charging modules shown in FIG. 11 is coupled to a pillar.

Hereinafter, detailed embodiments will be described in detail with reference to the accompanying drawings.

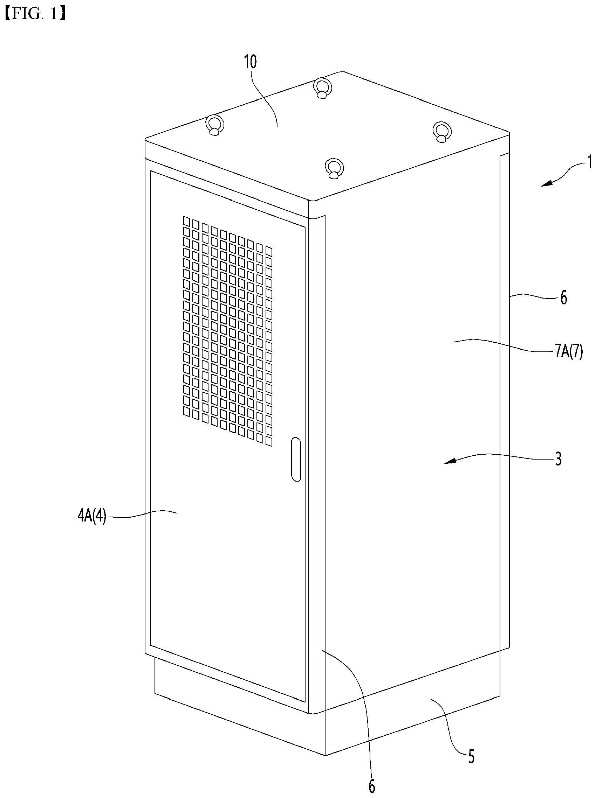

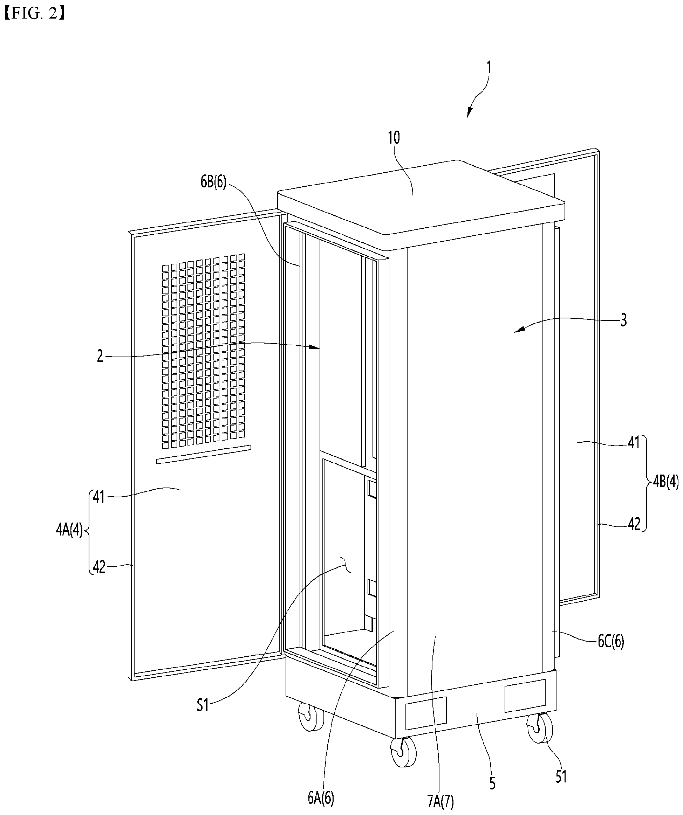

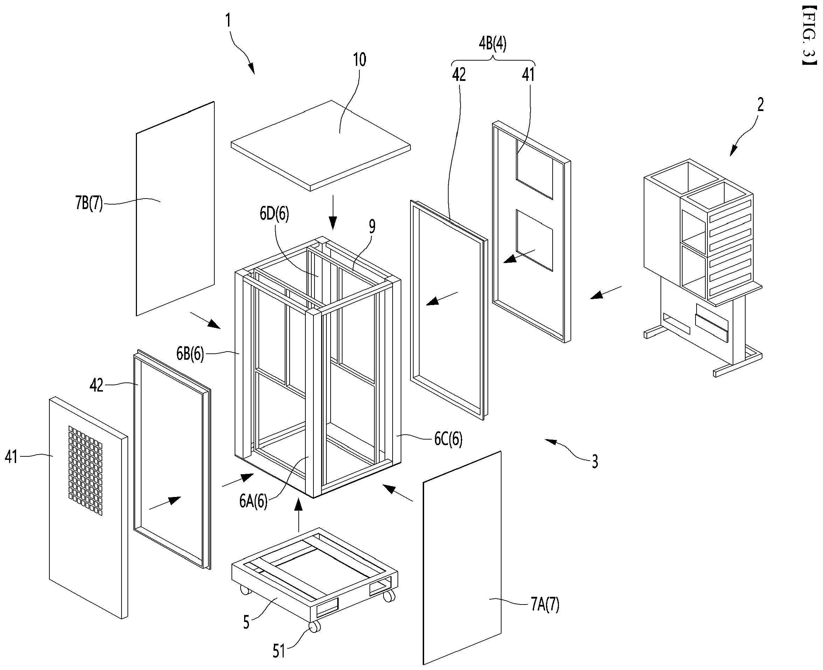

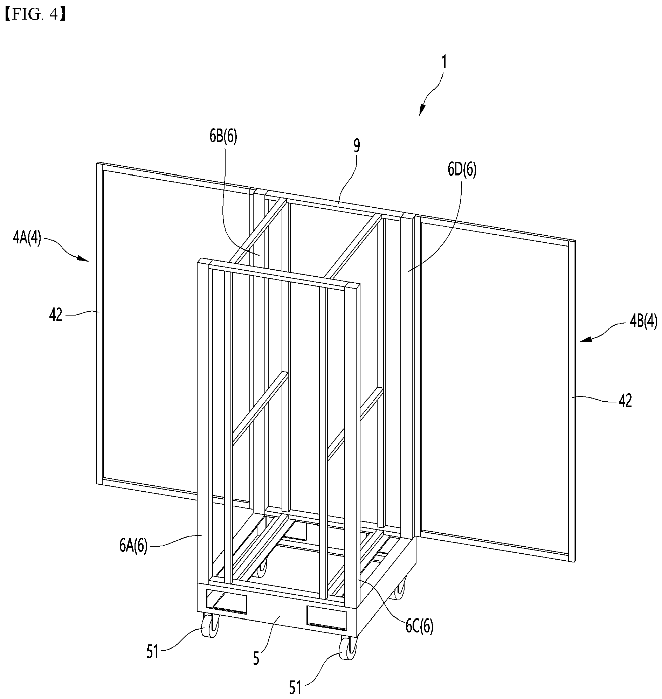

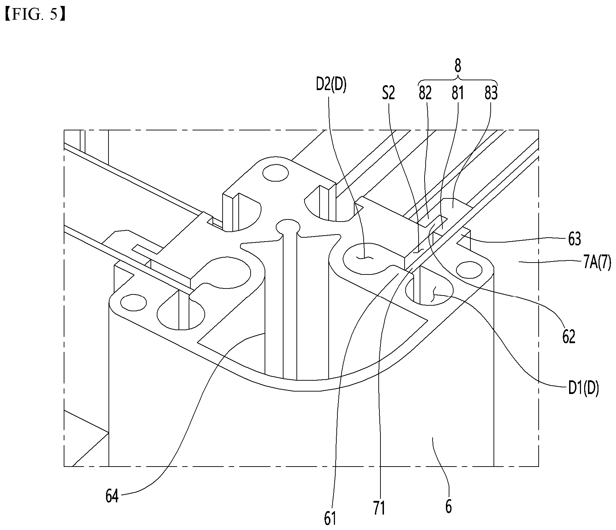

FIG. 1 is a perspective view of an example charger according to this embodiment; FIG. 2 is a perspective view when the door shown in Figure 1 is opened; FIG. 3 is an exploded perspective view of an example of a charger according to this embodiment; FIG. 4 is a view when the outer cover and top cover according to this embodiment are separated; and FIG. 5 is an enlarged perspective view when the outer cover according to this embodiment is coupled to the corner pillar.

The charger may comprise a cabinet 1 forming the exterior, and a space S may be formed inside the cabinet 1.

The charger may comprise internal components 2 accommodated in the space S. The internal component 2 may comprise a charging cable connector to which the charging cable is connected. The internal components 2 may comprise various components for charging an electric vehicle, and may comprise, for example, a power supply, circuit breaker, terminal, etc.

The cabinet 1 may comprise a cabinet body 3 with a space S1 formed therein, and a door 4 that opens and closes the space S 1.

The front surface and back surface of the cabinet body 3 may be open, and a plurality of doors 4 may be provided in the charger.

The plurality of doors 4 may comprise a front door 4A and a rear door 4B.

The front door 4A can be rotatably disposed on the front portion of the cabinet body 3 and can open and close an open front of the cabinet body 3.

The rear door 4B can be rotatably disposed at the rear portion of the cabinet body 3 and can open and close the open rear of the cabinet body 3.

The front door 4A and the rear door 4B may be symmetrical front and rear and may have the same structure.

The door 4 may comprise a door body 41 and a door gasket bracket 42.

Each of the front door 4A and the rear door 4B may comprise a door body 41 and a door gasket bracket 42.

At least one through hole for ventilation may be formed in the door body 41.

The door body 41 may be coupled with the door gasket bracket 42.

An example of the door gasket bracket 42 may be connected to the cabinet body 3 with a hinge, and the door gasket bracket 42 may rotate together with the door body 41.

Another example of the door gasket bracket 42 may be fixedly mounted on the cabinet body 3, and the door gasket bracket 42 may be connected to the door body 41 with a hinge, and the door body 41 may be connected to the door gasket and may be rotated based on the bracket 42.

The cabinet body 3 may be composed of a combination of a plurality of members.

The cabinet body 3 may comprise a base 5, a corner pillar 6, an outer cover 7, and a gasket 8.

The base 5 may form the bottom appearance of the cabinet 1.

A caster 51 or a wheel may be placed on the base 5.

The base 5 can support the corner pillar 6 and the outer cover 7.

The corner pillars 6 may be erected on the base 5. The corner pillar 6 may be disposed on the upper surface of the base 5. The corner pillar 6 may be erected at the corners of the base 5.

The corner pillar 6 may be a corner of the cabinet 1, especially the cabinet body 3.

A plurality of corner pillars 6 may be provided in the cabinet 1. The plurality of corner pillars 6 may be spaced apart in the horizontal direction. The plurality of corner pillars 6 may be spaced apart in the left and right direction and in the front and rear direction.

The plurality of corner pillars 6 may comprise a front left pillar 6A, a front right pillar 6B, a rear left pillar 6C, and a rear right pillar 6D. Hereinafter, the common configuration of the front left pillar 6A, the front right pillar 6B, the rear left pillar 6C, and the rear right pillar 6D will be described and referred to as the corner pillar 6.

As shown in FIG. 5, the corner pillar 6 may be formed with a cover insertion hole S2 into which the end 71 of the outer cover 7 is slidably inserted and a drainage channel D through which water is drained.

The cover insertion hole S2 may be in communication with the drainage channel D. The cover insertion hole (S2) may be formed between the outer surface of the corner pillar (6) and the drainage channel (D). The cover insertion hole S2 may be formed to be open in the front and rear direction or left and right direction. The cover insertion hole S2 may be a slit formed in the corner pillar 6 in the longitudinal direction of the corner pillar 6. The cover insertion hole S2 may be a slit formed in the corner pillar 6 in the vertical direction. The cover insertion hole S2 may be formed from the top to the bottom of the corner pillar 6. The cover insertion hole S2 may be a slide hole into which the end 71 of the outer cover 7 is slidably inserted. The cover insertion hole S2 may be a mounting hole where the outer cover 7 is mounted.

The cover insertion hole S2 may be formed in each of the plurality of corner pillars 6.

A cover insertion hole S2 may be formed in each of the front left pillar 6A, the front right pillar 6B, the rear left pillar 6C, and the rear right pillar 6D, and the end portion 71 of the outer cover 7 may be slidably inserted into the cover insertion hole S2 formed in each of the pair of corner pillars 6.

The drain channel D may be formed long inside the corner pillar 6 in the longitudinal direction of the corner pillar 6. The draina channel D may be formed to be long in the vertical direction on the corner pillar 6.

The drain channel D may comprise a pair of divided drain channels D1 and D2. A pair of divided drain channels D1 and D2 may be formed symmetrically.

A stopper 61 may be formed on the corner pillar 6. the end 71 of the outer cover 7 may be caught by contacting the stopper 61.

The stopper 61 may protrude into the drain channel D and may be formed between a pair of divided drain channels D1 and D2. The drain channel D may be divided into a pair of divided drain channels D1 and D2 by the stopper 61 and the outer cover 7.

The stopper 61 may protrude from the inside of the corner pillar 6 toward the cover insertion hole S2, and the end 71 of the outer cover 7 is inserted into the cover insertion hole S2, and then can get caught by contacting the stopper 61.

The stopper 61 can limit excessive insertion of the outer cover 7.

The corner pillar 6 may comprise a pillar body in which a cover insertion hole S2 and a drain channel D are formed.

The corner pillar 6 may comprise a gasket coupling body 62 surrounded by a gasket 8.

The gasket coupling body 62 may protrude from the outer surface of the corner pillar 6. The gasket coupling body 62 may protrude from the outer surface of the pillar body.

The corner pillar 6 may comprise a sliding guide 63 that guides the insertion of the outer cover 7.

The sliding guide 63 may protrude from the outer surface of the corner pillar 6. The sliding guide 63 may protrude from the outer surface of the pillar body.

The sliding guide 63 may be spaced apart from the gasket coupling body 62 in the horizontal direction. The sliding guide 63 may be parallel to the gasket coupling body 62. The protrusion width of the sliding guide 63 may be the same as the protrusion width of the gasket coupling body 62.

The gasket coupling body 62 may be located inside the cabinet body 3 rather than the sliding guide 63, and the sliding guide 63 may be positioned outside the cabinet body 3 rather than the gasket coupling body 62.

The cover insertion hole S2 may also be formed between the sliding guide 63 and the gasket coupling body 62. The cover insertion hole S2 may be formed between the sliding guide 63 and the gasket coupling body 62 and on the pillar body.

The corner pillar 6 may have an opening 64 formed in the vertical direction. The opening 64 may be formed to be long in the vertical direction in the corner pillar 6. The opening 64 may be spaced apart from the drain channel D and the cover insertion hole S2.

The corner pillars 6 may be an aluminum extrusion pillar manufactured by an aluminum(AL) extrusion process.

The outer cover 7 may be coupled to the corner pillar 6.

The outer cover (7) can be inserted between the corner pillar (6) and the gasket (8).

A plurality of outer covers 7 may be provided in the cabinet 1. The plurality of outer covers 7 may be spaced apart in the horizontal direction. The plurality of outer covers 7 may be spaced apart in the left and right directions. The plurality of outer covers 7 may comprise a left cover 7A and a right cover 7B.

The left cover 7A can be inserted into the cover insertion hole S2 formed in each of the front left pillar 6A and the rear left pillar 6C.

The right cover 7B can be inserted into the cover insertion hole S2 formed in each of the front right pillar 6B and the rear right pillar 6D. The right cover 7B may be spaced apart from the left cover 7A in the left and right direction.

The end 71 of the outer cover 7 may be inserted into the corner pillar 6 through the gap between the gasket 8 and the sliding guide 63.

The outer cover 7 may be a steel plate.

The gasket 8 may be placed on the corner pillar 6, as shown in FIG. 5. The gasket 8 may be located between the outer cover 7 and the corner pillar 6 when the outer cover 7 is installed.

The gasket 8 can seal between the outer cover 7 and the corner pillar 6. The gasket 8 may be long in the vertical direction.

The cross section of the gasket 8 may be ' 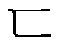 ' shaped.

The gasket 8 may comprise a first area 81, a second area 82, and a third area 83.

The first area 81 may be located between the outer cover 7 and the corner pillar 6. The first area 81 may be defined as a portion of the gasket 8 located between one surface of the outer cover 7 and the gasket coupling body 62 of the corner pillar 6.

The second area 82 may be located outside the corner pillar 6.

The second area 82 may be parallel to the first area 81.

The gasket coupling body 62 may be positioned between the first area 81 and the second area 82 when the gasket 8 is mounted on the corner pillar 6.

The third area 83 may connect the first area 81 and the second area 82.

When the gasket 8 is coupled to the gasket coupling body 62 and the end 71 of the outer cover 7 is inserted between the first area 81 of the gasket 8 and the sliding guide 62, the gasket 8 can be covered by the outer cover 7, and can be protected by the outer cover (7)

An example of the gasket 8 may be a silicon gasket made of silicon material.

Another example of the gasket 8 may be an aluminum gasket formed of aluminum material.

The cabinet body 3 may further comprise an inner frame 9 coupled to the corner pillar 6 and a top cover 10 that forms the upper exterior of the charger.

The inner frame 9 can connect a plurality of corner pillars 6.

The inner frame 9 may be composed of a combination of a plurality of horizontal beams and a plurality of vertical beams.

The top cover 10 may be disposed on the inner frame 9 and the plurality of pillars 6.

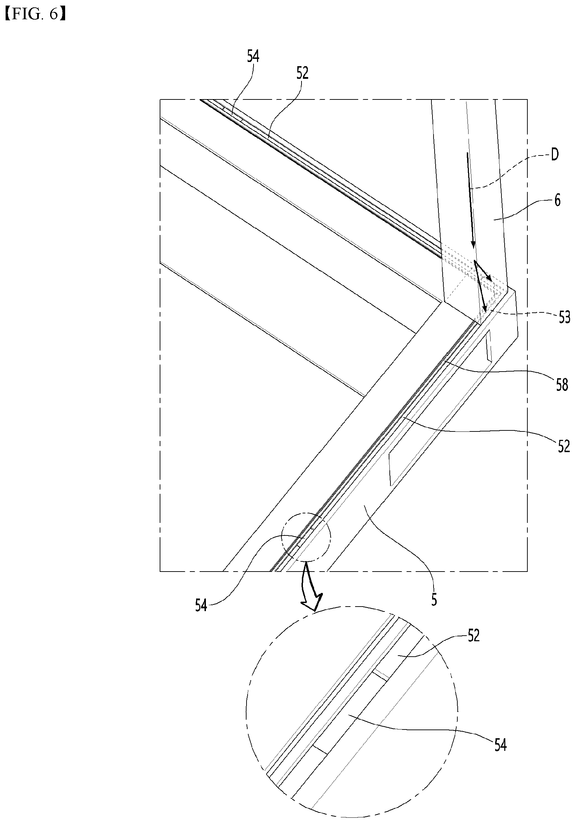

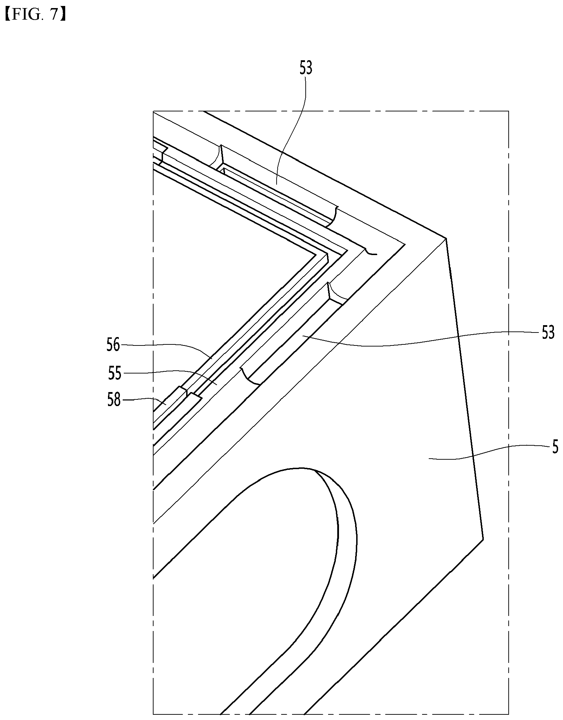

FIG. 6 is a perspective view showing a corner pillar and base according to this embodiment; and FIG. 7 is a perspective view when the corner pillar according to this embodiment is separated from the base.

A base drain channel 52 through which water is guided may be formed on the upper surface of the base 5. The base drain channel 52 may be formed to be long in the front and back direction or left right direction.

A plurality of drain holes 53 and 54 through which water falls may be formed in the base drain channel 52.

The plurality of drain holes 53 and 54 may comprise a main drain hole 53.

The main drain hole 53 may be formed below the drain channel D of the corner pillar 6 (refer to FIG. 5).

The main drain hole 53 may face the drain channel D of the corner pillar 6 in the vertical direction. Water that falls through drain channel D of the corner pillar 6 may fall through the main drain hole 53.

The main drain hole 53 may be formed at a corner of the base 5 to be open in the vertical direction.

The plurality of drain holes 53 and 54 may comprise a sub drain hole 54.

The sub drain hole 54 may be spaced apart from the main drain hole 53.

The sub drain hole 54 may be formed in an area of the base 5 that does not coincide with the corner pillar 6 in the vertical direction. The sub drain hole 54 may be formed to be open in the vertical direction other than at the corners of the base 5.

Water guided to the base drain channel 52 may fall through the sub drain hole 54.

A pair of ribs 55 and 56 may be formed on the upper surface of the base 5.

A pair of ribs 55 and 56 may be formed to be spaced apart in the horizontal direction. A pair of ribs 55 and 56 may be located inside the base drain channel 52. The pair of ribs 55 and 56 comprise an outer rib 55 located relatively outside and an inner rib 56 located relatively inside. The outer rib 55 may form the base drainage channel 52.

The charger may further comprise a base gasket 58.

The base gasket 58 may be mounted on a pair of ribs 55 and 56. The base gasket 58 may be fitted between a pair of ribs 55 and 56 and mounted on the base 5.

The base gasket 58 can be in contact with the bottom of the outer cover 7 and can prevent water from penetrating between the base 5 and the bottom of the outer cover 7.

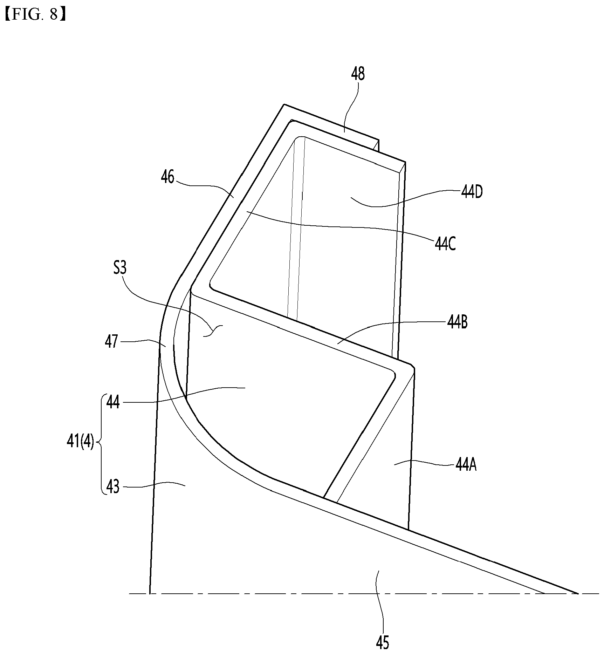

FIG. 8 is a partially cut away perspective view showing a door according to this embodiment.

The door 4 may comprise an outer door 43 forming the exterior of the door 4 and an inner door 44 disposed inside the outer door 43 and bent at least once.

The outer door 43 and the inner door 44 may form the door body 41 shown in FIGS. 1 to 3.

The outer door 43 may be a steel plate.

Each of the front door 4A and the rear door 4B may comprise an outer door 43 and an inner door 44.

The outer door 43 comprises a plate portion 45 forming the front exterior or rear exterior, a side portion 46 perpendicular to the plate portion 45, and a connecting portion 47 connecting the plate portion 45 and the side portion 46.

The connecting portion 47 may be formed in a curved shape.

A bent portion 48 may be formed at an end of the side portion 46.

An accommodating space S3 in which all or part of the inner door 44 can be accommodated may be formed in the outer door 43.

The receiving space S3 may be formed between the bent portion 48 and the connecting portion 47.

The inner door 44 has a first area 44A whose end is in contact with the plate portion 45, a second area 44B bent from the first area 44A, a third region 44C that is in surface contact with the side portion 46, and a fourth region 44D that is in surface contact with the bent portion 48. The third region 44C may be bent from the second area 44B. The fourth region 44D may be bent from the third region 44C.

The fourth area 44D may be parallel to the second area 44B.

The inner door 44 may be an aluminum extrusion door.

The inner door 44 may be fitted inside the outer door 43 and fixed to the outer door 43.

A portion of the inner door 44 may be accommodated in the accommodation space S3 and may be in surface contact with the outer door 43.

The inner door 44 can reinforce the strength of the door 4, and even if water penetrates, rust does not occur in the inner door 4, and the reliability of the door 4 can be ensured.

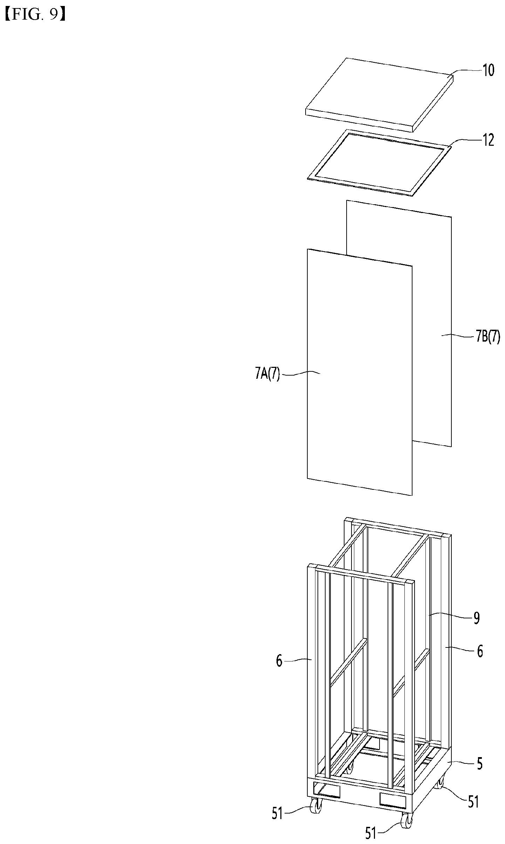

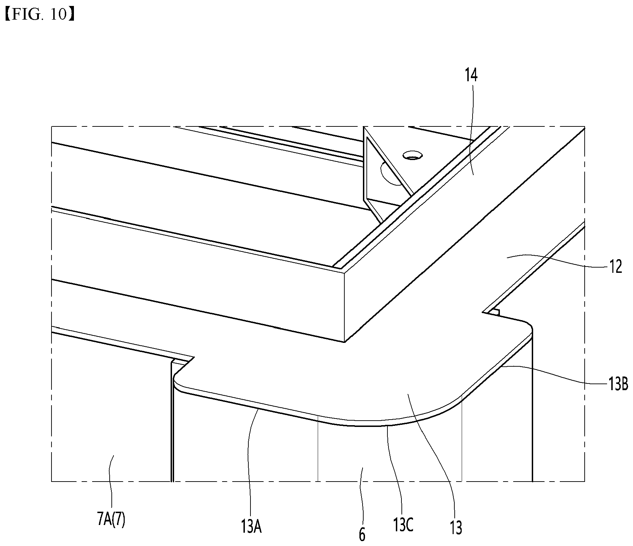

FIG. 9 is an exploded perspective view showing another example of the cabinet body according to this embodiment; and FIG. 10 is an enlarged view when the top cover shown in Figure 9 covers the top of the corner pillar.

The cabinet body 3 may comprise a base 5, a corner pillar 6, an outer cover 7, an inner frame 9, a top cover 10, and an upper cover 12.

The base 5, the corner pillar 6, the outer cover 7, the inner frame 9, and the top cover 10 may be the same or similar to those of the cabinet body 3 shown in Figure 3. In order to avoid duplicate descriptions, the same symbols are used and detailed descriptions thereof are omitted.

The upper cover 12 may comprise a shielding body 13 that shields the top of the corner pillar 6.

The shielding body 13 may protrude in the horizontal direction from the vertex of the upper cover 12.

The edge of the shielding body 13 may comprise a pair of straight portions 13A and 13B and a round portion 13C connecting the pair of straight portions 13A and 13B.

A pair of straight portions 13A and 13B may be perpendicular to each other. One of the pair of straight portions 13A and 13B may be long in the front and rear direction, and the other of the pair of straight portions 13A and 13B may be long in the left and right directions.

The upper cover 12 may comprise a protruding body 14 inserted into the inside of the top cover 10.

The protruding body 14 may protrude upward.

The upper cover 12 may be a blocking cover that prevents foreign substances such as water from flowing into the opening 64 of the corner pillar 6, the drain channel D, and the cover insertion hole S2.

The top cover 10 may cover the inside of the upper cover 12 and the cabinet body 3 from the upper side of the upper cover 12. The top cover 10 can be fitted with the protruding body 14 and can hide the protruding body 14.

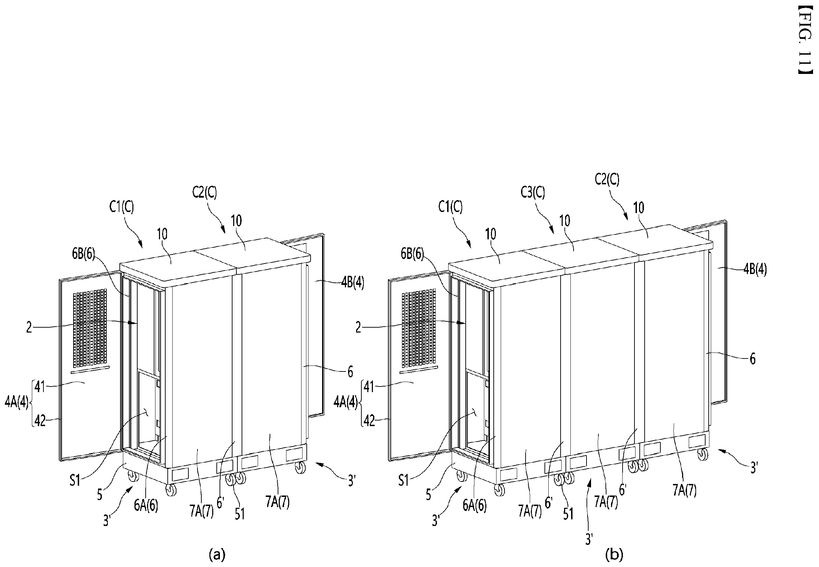

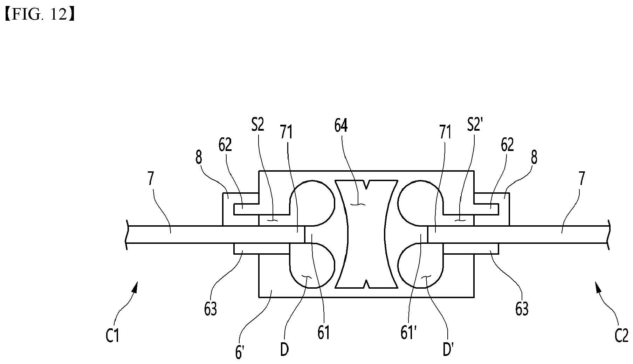

FIG. 11 is a perspective view of another example of the charger according to this embodiment when the door is opened; and FIG. 12 is a plan view when the outer cover of each of charging modules shown in FIG. 11 is coupled to a pillar.

Another example of a charger may comprise a plurality of charging modules C.

A plurality of charging modules C may be arranged in a row in the front and rear direction.

The plurality of charging modules C may be two charging modules C1 and C2 arranged in a row or three or more charging modules C1, C2 and C3) may be arranged in a row.

Fig 11 (a) shows an example in which two charging modules are arranged in a row, and Fig 11 (b) shows an example in which three charging modules are arranged in a row.

Each of the plurality of charging modules C may comprise a cabinet body 3' with a space S1 formed therein, and components 2 disposed inside the cabinet body 3'.

The cabinet body 3' of each of the plurality of charging modules C may be arranged in a row in the front and rear direction.

Each cabinet body 3' of a plurality of charging modules C comprises a base 5; a pillar erected on base; a gasket disposed on the pillar; and an outer cover (7) fitted between the gasket 8 and the pillar.

The pillar of the cabinet body 3' may comprise a corner pillar 6, a common pillar 6', or may comprise only the common pillar 6'.

The corner pillar 6 may be a pillar that forms the corner of the charger.

The common pillar 6' may be a pillar shared with the cabinet body 3' of other adjacent charging module.

The internal components 2, the base 5, the corner pillar 6, the gasket 8, and the outer cover 7 may be the same or similar to those of the charger shown in FIGs. 1 to 7, To avoid redundant description, the same symbols are used and detailed descriptions thereof are omitted.

As shown in Fig 11 (a). 11, when two charging modules C1 and C2 are arranged in a row, each cabinet body 3' has a corner pillar 6 forming a corner of the charger; and a common pillar 6' shared with the cabinet body (3') of other adjacent charging modules.

As shown in Fig 11 (b), when three or more charging modules C1, C2 and C3 are arranged in a row, the charger comprises a forefront charging module C1, at least one middle charging module C3 and a rearmost charging module C2, and each of the cabinet body 3' of the forefront charging module C1 and the cabinet body 3' of the rearmost charging module C2 have a corner pillar 6 and a common pillar 6', and the cabinet body 3' of the middle charging module C3 may comprise a plurality of common pillars 6'.

The charger may further comprise a front door 4A coupled to the cabinet body 3' of the charging module C1 located at the forefront among the plurality of charging modules C, and a rear door (4B) coupled to the cabinet body 3' of the charging module C2 located at the rearmost among the plurality of charging modules C.

The front door 4A and the rear door 4B may be the same or similar to the front door 4A and the rear door 4B shown in Fig. 3, and to avoid redundant description, the same symbols are used and Detailed description is omitted.

Hereinafter, for convenience of explanation, an example will be given in which two charging modules C1 and C2 are arranged in a row, but of course, the number of charging modules C1 and C2 is not limited.

The common pillar 6' may be defined as a pillar located between adjacent cabinet bodies 3' among the pillars 6 and 6'.

The common pillar 6' has a first cover insertion hole S2 into which the end of the outer cover 7 of one of the adjacent cabinet bodies 3' is slid, and a second cover insertion hole S2' into which the end of the outer cover 7 of the other of the adjacent cabinet bodies 3' is slid.

The first cover insertion hole S2 and the second cover insertion hole S2' may be opened in opposite directions.

The first cover insertion hole S2 may be an insertion hole open in the front direction of the common pillar 6'.

The second cover insertion hole S2' may be an insertion hole open toward the rear of the common pillar 6'.

The first cover insertion hole S2 and the second cover insertion hole S2' may be symmetrical front and rear.

The common pillar 6' may comprise a first drain channel D communicating with the first cover insertion hole S2, and a second drain channel D' communicating with the second cover insertion hole S2'.

The first drain channel D and the second drain channel D' may be spaced apart from each other. The first drain channel D and the second drain channel D' may be spaced apart from each other in the front and rear direction.

The common pillar 6' may be formed with a first stopper 61. The end 71 of the outer cover 7 of one of the adjacent cabinet bodies 3' can be caught by contacting the first stopper 61.

The first stopper 61 may protrude in the front direction and divide the first drain channel D into a pair of divided drain channels.

The common pillar 6' may be formed with a second stopper 62. The end 71 of the outer cover 7 of the other of the adjacent cabinet bodies 3' can be caught by contacting the second stopper 61.

The second stopper 61' may protrude in the rear direction to divide the second drain channel D' into a pair of divided drain channels.

The common pillar 6' may have an open 64 formed in the vertical direction.

The opening 64 may be formed between the first drain channel (D) and the second drain channel D', and may be spaced apart from each of the first drain channel (D) and the second drain channel D'.

A gasket coupling body 62 surrounded by a gasket 8 and a sliding guide 63 that guides the insertion of the outer cover 7 may protrude from the front and rear surfaces of the common pillar 6', respectively.

According to this embodiment, since the outer cover is slidably inserted and fitted into the cover insertion hole formed in the corner pillar, assembly of the outer cover and the corner pillar is easy.

In addition, water infiltration can be minimized by the gasket inserted between the outer cover and the corner pillar, and the outer cover can be firmly maintained on the corner pillar.

In addition, water can be drained through a drain channel formed in the cornor pillar, so water can be drained quickly.

In addition, water guided through the drain of the corner pillar falls through the main drain hole of the base, allowing water to be drained quickly.

In addition, water guided through the base drain channel falls through sub drain hole, thereby minimizing water remaining on the upper surface of the base.

In addition, the outer covers of each of the plurality of charging modules can be slid and mounted on the pillar located between the plurality of charging modules, so that the plurality of charging modules can be easily expanded.

The above description is merely an example of the technical idea of the present invention, and various modifications and variations can be made to those skilled in the art without departing from the essential characteristics of the present invention.

Therefore, the embodiments disclosed in the present invention are not intended to limit the technical idea of the present invention, but to explain, and the scope of the technical idea of the present invention is not limited by these embodiments.

The protection scope of the present invention should be construed according to the claims below, and all technical ideas within the equivalent range should be construed as being comprised in the scope of the present invention.

## Claims

1. A charger comprising:
a cabinet body (3) with a space (S1) formed inside of the cabinet body (3); and
a door (4) configured to open and close the space (S1),
wherein the cabinet body (3) comprise;
a base (5);
a corner pillar (6) erected on the base (5);
a gasket (8) disposed on the corner pillar (6); and
an outer cover (7) fitted between the gasket (8) and the corner pillar (6),
wherein a cover insertion hole (S2) into which the outer cover (7) is inserted and a drain channel (D) through which water is drained are formed at the corner pillar (6),
wherein an end of the outer cover (7) is slidably inserted into the cover insertion hole (S2).

2. The charger according to claim 1,
wherein the cover insertion hole (S2) and the drain channel (D) are in communication.

3. The charger according to claim 1 or 2,
wherein the corner pillar (6) comprises a gasket coupling body (62) surrounded by the gasket (8).

4. The charger according to claim 3,
wherein the corner pillar (6) further comprises a sliding guide (63) guiding an insertion of the outer cover (7),
wherein the sliding guide (63) is parallel to the gasket coupling body (62).

5. The charger according to claim 4,
wherein the corner pillar (6) further comprises a pillar body in which the cover insertion hole (S2) and the drain channel (D) are formed,
where in the gasket coupling body (62) and the sliding guide (63) protrude from an outer surface of the pillar body.

6. The charger according to claim 4,
wherein the gasket coupling body (62) is located inside the sliding guide (63).

7. The charger according to any one of claims 1 to 6,
wherein a stopper (61) is formed in the corner pillar (6),
wherein the end of the outer cover (7) is caught by contacting the stopper(61).

8. The charger according to any one of claims 1 to 7, wherein a base drain channel (52) through which water is guided is formed on an upper surface of the base (5).

9. The charger according to claim 8,
wherein a plurality of drain holes (53,54) through which water falls are formed on the base drain channel (52).

10. The charger according to claim 9,
wherein the plurality of drain holes (53,54) comprise a main drain hole (53),
wherein the main drain hole (53) is formed below the drain channel (D),
wherein the main drain hole (53) faces the drain channel (D) in an upward and downward direction.

11. The charger according to claim 10,
wherein the plurality of drain holes (53,54) comprise a sub drain hole (54) spaced apart from the main drain hole.

12. The charger according to any ono of claims 1 to 11,
wherein a pair of ribs (55,56) are formed on an upper surface of the base (5),
wherein the pair of ribs (55,56) are horizontally spaced apart from each other,
wherein the charger further comprise a base gasket (58) mounted on the pair of ribs (55,56).

13. The charger according to any one of claims 1 to 12,
wherein the corner pillar (6) is an aluminum extrusion pillar,
wherein the outer cover (7) is a steel plate.

14. The charger according to any one claims 1 to 13,
wherein the door (4) comprise;
an outer door (43) forming an exterior of the door (4).
an inner door (44) disposed inside the outer door (43) and bent at least once,
wherein an accommodating space (S3) in which all or part of the inner door (44) accommodated is formed in the outer door (43),
wherein the inner door (44) is inserted inside the outer door (43) and fixed to the outer door (43),
wherein the outer door (43) is a steel plate,
wherein the inner door (44) is an aluminum extrusion door (4).

15. The charger according to any one of claims 1 to 14,
wherein a plurality of the cabinet bodies (3') are arranged in a row,
wherein a pair of adjacent cabinet bodies (3') comprise a common pillar (6'),
wherein a first cover insertion hole(S2) and a second cover insertion hole (S2') are formed at the common pillar (6'),
wherein an end of an outer cover of one of adjacent cabinet bodies (3') is slid into the first cover insertion hole (S2),
wherein an end of an outer cover of the other of the adjacent cabinet bodies (3') is slid into the second cover insertion hole (S2'),
wherein the first cover insertion hole (S2) and the second cover insertion hole (S2') are open in opposite directions.

## Amended claims

### Amended claims in accordance with Rule 137(2) EPC.

1. A charger for charging electric energy comprising:
a cabinet body (3) with a space (S 1) formed inside of the cabinet body (3); and
a door (4) configured to open and close the space (S1),
wherein the cabinet body (3) comprises;
a base (5);
a corner pillar (6) erected on the base (5);
a gasket (8) disposed on the corner pillar (6); and
an outer cover (7) fitted between the gasket (8) and the corner pillar (6),
wherein a cover insertion hole (S2) into which the outer cover (7) is inserted and a drain channel (D) through which water is drained are formed at the corner pillar (6),
wherein an end of the outer cover (7) is slidably inserted into the cover insertion hole (S2),
**characterized in that** the cover insertion hole (S2) and the drain channel (D) are in communication.

2. The charger according to claim 1,
wherein the corner pillar (6) comprises a gasket coupling body (62) surrounded by the gasket (8).

3. The charger according to claim 2,
wherein the corner pillar (6) further comprises a sliding guide (63) guiding an insertion of the outer cover (7),
wherein the sliding guide (63) is parallel to the gasket coupling body (62).

4. The charger according to claim 3,
wherein the corner pillar (6) further comprises a pillar body in which the cover insertion hole (S2) and the drain channel (D) are formed,
where in the gasket coupling body (62) and the sliding guide (63) protrude from an outer surface of the pillar body.

5. The charger according to any one of claims 1 to 4,
wherein a stopper (61) is formed in the corner pillar (6),
wherein the end of the outer cover (7) is caught by contacting the stopper(61).

6. The charger according to any one of claims 1 to 5, wherein a base drain channel (52) through which water is guided is formed on an upper surface of the base (5).

7. The charger according to claim 6,
wherein a plurality of drain holes (53,54) through which water falls are formed on the base drain channel (52).

8. The charger according to claim 7,
wherein the plurality of drain holes (53,54) comprise a main drain hole (53),
wherein the main drain hole (53) is formed below the drain channel (D),
wherein the main drain hole (53) faces the drain channel (D) in an upward and downward direction.

9. The charger according to claim 8,
wherein the plurality of drain holes (53,54) comprise a sub drain hole (54) spaced apart from the main drain hole.

10. The charger according to any ono of claims 1 to 9,
wherein a pair of ribs (55,56) are formed on an upper surface of the base (5),
wherein the pair of ribs (55,56) are horizontally spaced apart from each other,
wherein the charger further comprise a base gasket (58) mounted on the pair of ribs (55,56).

11. The charger according to any one of claims 1 to 10,
wherein the corner pillar (6) is an aluminum extrusion pillar,
wherein the outer cover (7) is a steel plate.

12. The charger according to any one claims 1 to 11,
wherein the door (4) comprise;
an outer door (43) forming an exterior of the door (4).
an inner door (44) disposed inside the outer door (43) and bent at least once, wherein an accommodating space (S3) in which all or part of the inner door (44) accommodated is formed in the outer door (43),
wherein the inner door (44) is inserted inside the outer door (43) and fixed to the outer door (43),
wherein the outer door (43) is a steel plate,
wherein the inner door (44) is an aluminum extrusion door (4).

13. The charger according to any one of claims 1 to 12,
wherein a plurality of the cabinet bodies (3') are arranged in a row,
wherein a pair of adjacent cabinet bodies (3') comprise a common pillar (6'),
wherein a first cover insertion hole(S2) and a second cover insertion hole (S2') are formed at the common pillar (6'),
wherein an end of an outer cover of one of adjacent cabinet bodies (3') is slid into the first cover insertion hole (S2),
wherein an end of an outer cover of the other of the adjacent cabinet bodies (3') is slid into the second cover insertion hole (S2'),
wherein the first cover insertion hole (S2) and the second cover insertion hole (S2') are open in opposite directions.
